(19) Europäisches Patentamt
European Patent Office
Office européen des brevets

(11) **EP 0 889 587 B1**

(12) **EUROPÄISCHE PATENTSCHRIFT**

(45) Veröffentlichungstag und Bekanntmachung des Hinweises auf die Patenterteilung:
**16.11.2005   Patentblatt 2005/46**

(51) Int Cl.$^7$: **H03H 17/06**

(21) Anmeldenummer: **97110913.7**

(22) Anmeldetag: **02.07.1997**

(54) **Einrichtung zur Reduktion der Datenrate**

Device for reducing data rate

Dispositif pour la réduction du flot de données

(84) Benannte Vertragsstaaten:
**DE FR GB IT NL**

(43) Veröffentlichungstag der Anmeldung:
**07.01.1999   Patentblatt 1999/01**

(73) Patentinhaber: **Micronas Semiconductor Holding AG**
**8005 Zürich (CH)**

(72) Erfinder: **Menkhoff, Andreas, Dr.**
**81927 München (DE)**

(74) Vertreter: **Hornig, Leonore**
**MICRONAS GmbH,**
**Patentabteilung,**
**Hans-Bunte-Strasse 19**
**79108 Freiburg (DE)**

(56) Entgegenhaltungen:
**EP-A- 0 176 946        EP-A- 0 320 517**

• **SHUNI CHU ET AL: "MULTIRATE FILTER DESIGNS USING COMB FILTERS" IEEE TRANSACTIONS ON CIRCUITS AND SYSTEMS., Bd. 31, Nr. 11, November 1984, NEW YORK US, Seiten 913-924, XP002049419**

## Beschreibung

Die Erfindung betrifft eine Einrichtung zur Reduktion der Datenrate einer Datenfolge, die insbesondere dazu dient, die Abtastrate von digitalisierten Signalen um einen nichtganzzahligen Faktor zu reduzieren. Derartige Einrichtungen sind beispielsweise dort erforderlich, wo vorgegebenen Datenfolgen an unterschiedliche Verarbeitungstakte angepaßt werden sollen, die eigentlichen Signalinhalte aber nicht verändert werden sollen. Derartige Anwendungen betreffen insbesondere überabgetastete Audiosignale, aber auch Video- und andere Signale, deren Abtasttakt um einen nichtganzzahligen Faktor für die weitere Verarbeitung oder Speicherung zu reduzieren ist. Die Erfindung kann ferner auch dort angewendet werden, wo der Signalinhalt verändert werden soll, beispielsweise ermöglicht die Erfindung bei Videosignalen eine verkleinerte Bildwiedergabe, indem durch die Reduktion der Datenanzahl jedoch unter Beibehaltung der Datenrate ein verkleinertes Bild in einem Bildfenster eines Fernseh- oder Computer-Bildschirms darstellbar ist. Das verbleibende Bild kann beispielsweise ein Standbild, ein laufendes Fernsehbild oder eine computergesteuerte Animation sein.

Im allgemeinen werden für derartige Anwendungen relativ aufwendige Interpolationsfilter mit transversalen und/oder rekursiven Filterstufen verwendet, um eine nichtganzzahlige Reduktion der Datenrate zu ermöglichen. Eine Beschreibung derartiger Abtastraten-Umsetzungseinrichtungen findet sich beispielsweise in "Transactions on Acoustics, Speech, and Signal Processing", Band ASSP-32, Nr. 3, Juni 1984, Seiten 577 bis 591 unter dem Titel: "Digital Methods for Conversion Between Arbitrary Sampling Frequencies" von Tor A. Ramstad.

Die Einrichtungen zur Reduktion der Datenrate sind relativ einfach zu realisieren, wenn sich die alte und neue Datenrate in aufeinanderfolgenden gleichen Abtastintervallen nur um einen Abtastwert unterscheiden. Beispielsweise wenn aus drei aufeinanderfolgenen Abtastwerten zwei neue Abtastwerte gebildet werden sollen. Dies entspricht einem Datenrate-Reduktionsfaktor r = 1,5. Oder wenn aus zehn alten Abtastwerten neun neue Abtastwerte zu interpolieren sind, dies entspricht einem Daten-Reduktionsfaktor r = 10/9. Für diese speziellen Datenrate-Reduktionsfaktoren sind sehr einfache Filtereinrichtungen bekannt, bei denen in regelmäßigen Intervallen jeweils ein Abtastwert weggelassen wird und die verbleibende Datenfolge mit einem digitalen Tiefpaßfilter geglättet wird.

Besonders einfache Schaltungen und Verfahren sind bekannt, wenn die Reduktion der Datenrate um einen ganzzahligen Reduktionsfaktor r erfolgt. Dabei werden jeweils mehrere Datenwerte, die ein Datenfenster bilden, zu einem neuen Datenwert zusammengezogen und die Folge aus den neuen Datenwerten bildet dann die gewünschte neue Datenfolge. In der digitalen Signalverarbeitung wird diese Art der Abtastratenreduktion auch als Dezimierung bezeichnet. Die Datenwerte im Datenfenster können dabei entsprechend dem gewählten Interpolationsverfahren mit einer zugehörigen Gewichtungsfunktion modifiziert werden. Aufgrund des einfachsten Gewichtungsfalles, bei dem die Daten innerhalb des Datenfensters nicht gewichtet werden, werden diese Schaltungen auch als "Kammfilter" bezeichnet. Eine Beschreibung hierzu findet sich in "IEEE Transactions on Circuits and Systems", Band CAS-31, Nr. 11, November 1984, Seiten 913 bis 924 unter dem Titel: "Multirate Filter Designs Using Comb Filters" von Shuni Chu und C. Sidney Burrus.

Derartige Kammfilter umfassen in der Regel mindestens einen Akkumulator, einen Dezimierungsschalter, der nach der vorgegebenen Zahl von Abtastwerten geschlossen wird und einen Differenzierer. Jeder Akkumulator und Differenzierer enthält dabei eine Verzögerungsstufe und einen Addierer bzw. Subtrahierer. Die Addierer und Differenzierer bilden zusammen ein mitlaufendes Datenfenster zur Bildung des interpolierten Abtastwertes. Der einzelne Akkumulator bewirkt keine Gewichtung. Durch zwei oder mehr in Reihe geschaltete Akkumulatoren und eine gleichgroße Anzahl von in Reihe geschalteten Differenzierern können jedoch auch Gewichtungsfunktionen höherer Ordnung gebildet werden. Wird der letzte Akkumulator als rücksetzbarer Akkumulator ausgebildet, der zusammen mit dem Dezimierungsschalter zurückgesetzt wird, dann reduziert sich die Anzahl der erforderlichen Differenzierer um einen Differenzierer. Die Kammfilterstruktur hat auch den Vorteil, daß der hohe Verarbeitungtakt nur für die Akkumulatoren erforderlich ist, während die Differenzierer mit dem niederen Takt des Dezimierungsschalters arbeiten.

Es ist Aufgabe der Erfindung, eine einfache Schaltung zur Reduktion der Datenrate um einen nichtganzzahligen Reduktionsfaktor, der sich als eine rationale Zahl darstellen läßt, anzugeben.

Die Lösung der Aufgabe erfolgt entsprechend den Merkmalen des Anspruchs 1 durch:

- eine umschaltbaren Filtereinrichtung, die in einem ersten Schaltzustand erste Ausgangswerte nach a Abtastschritten und in einem zweiten Schaltzustand zweite Ausgangswerte nach a + 1 Abtastschritten liefert und zur Bildung gefilterter Datenwerte mindestens ein mitlaufendes Datenfenster aufweist, wobei im Falle

- nur eines mitlaufenden Datenfensters diesem mindestens zwei unterschiedliche Fenstergrößen zugeordnet sind, deren Auswahl von der Folge der ersten und zweiten Ausgangswerte abhängig ist, oder

- bei mehr als einem mitlaufenden Datenfenster diesen mindestens zwei unterschiedliche Fenstergrößen zugeordnet sind und die Auswahl des jeweiligen Datenfensters und der zugehörigen Fenstergröße von der Folge der ersten und zweiten Ausgangswerte abhängig ist, und

- die eine Fenstergröße b Abtastwerte und die andere Fenstergröße c Abtastwerte mit $b \geq a$ und $c \geq a + 1$ umfaßt, und

- eine mit der umschaltbaren Filtereinrichtung gekoppelten Steuereinrichtung, die mittels des ersten und zweiten Schaltzustandes innerhalb gleichlanger Abschnitte der Datenfolge die Bildung von n ersten Ausgangswerten, m zweiten Ausgangswerten und die Auswahl der zugehörigen Fenstergrößen oder Datenfenster bewirkt, dabei ist die Anzahl der n ersten und m zweiten Ausgangswerte durch eine Bemessungsregel $r = a + m/(n + m)$ bestimmt, wobei r ein Datenrate-Reduktionsfaktor ist.

Ein vorteilhaftes Ausführungsbeispiel der Erfindung ergibt sich für den ersten Fall, wenn als Grundstruktur für die umschaltbare Filtereinrichtung das bereits beschriebene Kammfilter, das eine einfache oder höhere Ordnung aufweisen kann, in Serienschaltung verwendet wird. Entsprechend der Ordnung ist die Anzahl der Akkumulatoren und Differenzierer vorzugeben, wobei die Anzahl der Differenzierer um Eins reduziert werden kann, wenn der letzte Akkumulator rücksetzbar ist. Die Realisierung der umschaltbaren Filtereinrichtung kann jedoch auch über andere Filterstrukturen oder rein über eine Programmsteuerung erfolgen, indem die vorgesehenen digitalen Übertragungsfunktionen durch geeignete Programme realisiert sind. Da in der digitalen Signalverarbeitung in der Regel normierte Signalbereiche verwendet werden, ist gegebenenfalls die umschaltbare Filtereinrichtung durch eine Amplituden-Normierungseinrichtung zu ergänzen, insbesondere wenn die Verstärkungen im ersten und zweiten Schaltzustand relativ unterschiedlich sind. In der neuen Datenfolge sind schließlich die ersten und zweiten Ausgangswerte möglichst gleichmäßig alternierend verteilt, so daß die interpolierten Abtastwerte zeitlich möglichst dicht bei den theoretischen Abtastwerten liegen.

Wenn an das Glättungsverhalten der umschaltbaren Filtereinrichtung höhere Anforderungen gestellt werden, dann verwendet man für die einzelnen Filter Filterstrukturen höherer Ordnung, beispielsweise nach Lagrange oder auch die bereits erwähnte Mehrfachanordnung von Kammfiltern. Diese Filterstrukturen müssen dabei wieder unterschiedliche Fenstergrößen aufweisen. Nachteilig können hierbei die unterschiedlichen Gruppenlaufzeiten sein, die zu Signalverfälschungen führen. Eine Kompensation dieser Gruppenlaufzeiten ist indessen möglich, wenn für die umschaltbare Filtereinrichtung separate Signalpfade verwendet werden, die aus jeweils einem Filter höherer Ordnung gebildet sind. Dies führt entsprechend dem zweiten Fall der angegebenen Lösung zu einer Parallelstruktur der umschaltbaren Filtereinrichtung, die entsprechende Ausgleichseinrichtungen für die Gruppenlaufzeit auf einfache Weise erlaubt. Eine Anpassung der einzelnen Gruppenlaufzeiten ist beispielsweise mittels unterschiedlicher Verzögerungseinrichtungen in den parallelgeschalteten Signalpfaden möglich. Die schnellere Filterstruktur wird damit gegenüben den langsameren Filterstrukturen um eine bestimmte Taktanzahl verzögert. Ferner wird bei der Verwendung von Kammfiltern durch die Vorgabe des Schließzeitpunktes des Dezimationsschalters und/oder der Reseteinrichtung das mitlaufende Datenfenster unabhängig vom anderen Kammfilter gestartet. Eine Kombinationseinrichtung greift an einem der parallelgeschalteten Filter den Ausgangswert ab und bildet über einen Pufferspeicher die gewünschte Ausgangs-Datenfolge.

Durch die Verzögerung der Datenausgabe in dem einen Filterzweig und durch die Wahl des Startzeitpunktes des Datenfensters im anderen Filterzweig kann unabhängig von der jeweiligen Filterart erreicht werden, daß die gefilterten Datenwerte immer rechtzeitig für die Kombinationseinrichtung zur Verfügung stehen, so daß das ausgangsseitige Umschalten auf den jeweiligen Filterzweig keine Signalunstetigkeit zur Folge hat.

Die Erfindung und weitere Vorteile werden nun anhand der Figuren der Zeichnung näher erläutert:

Fig.1    zeigt als Blockschaltbild ein Ausführungsbeispiel mit einer Serienstruktur,

Fig. 2    zeigt als Blockschaltbild ein Ausführungsbeispiel mit einer Parallelstruktur,

Fig. 3    zeigte als Blockschaltbild eine Filter-Parallelstruktur höherer Ordnung und

Fig. 4    zeigt als Blockschaltbild eine äquivalente Filterstruktur zu Fig. 3 und

Fig. 5    zeigt im Zeitdiagramm ein einfaches Beispiel zur Reduktion der Datenrate.

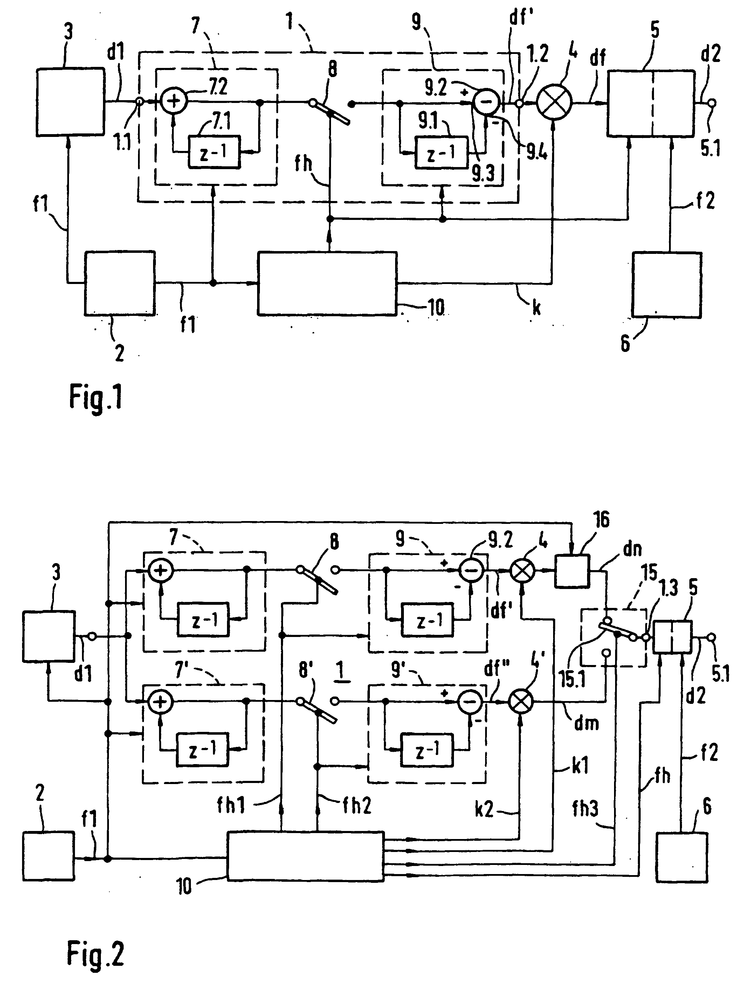

In Fig. 1 ist im Blockschaltbild als erstes Ausführungsbeispiel der Erfindung eine Einrichtung mit einer einfachen seriellen Filterstruktur zur Reduktion der Datenrate einer Datenfolge d1 dargestellt, die mittels einer umschaltbaren Filtereinrichtung 1 in eine Ausgangs-Datenfolge d2 umgesetzt wird. Die Datenrate der Eingangs-Datenfolge d1 entspricht einem ersten Takt f1, der einer ersten Taktquelle 2 entstammt und eine Datenquelle 3 steuert. Der erste Takt f1 kann auch einem Systemtakt entsprechen oder durch die Datenrate der Datenfolge d1 vorgegeben sein, aus der er mittels einer Phasenverriegelungsschleife (=PLL) wieder zurückgewonnen werden kann.

Die umschaltbare Filtereinrichtung 1 ist über den Filtereingang 1.1 an die Datenquelle 3 angeschlossen und gibt am Ausgang 1.2 erste gefilterte Datenwerte df' ab, die gegebenenfalls mit einer Amplituden-Normierungseinrichtung 4 in der Verstärkung noch angepaßt werden und dann die eigentlichen gefilterten Datenwerte df bilden. Die Amplitudenanpassung erfolgt durch einen einem Multiplizierer zugeführten Abschwächungsfaktor k, der beispielsweise die Werte k=1/b und k=1/c hat. Die gefilterten Datenwerte df gelangen schließlich auf einen Pufferspeicher 5, dessen Ausgangsstufe von einer zweiten Taktquelle 6 mit einem zweiten Takt f2 gesteuert ist. Dabei entspricht der zweite Takt f2 der gewünschten Datenrate der Ausgangsdatenfolge d2, die an einem Pufferausgang 5.1 abgreifbar ist, der damit auch Ausgang der gesamten Datenrate-Reduktionseinrichtung ist.

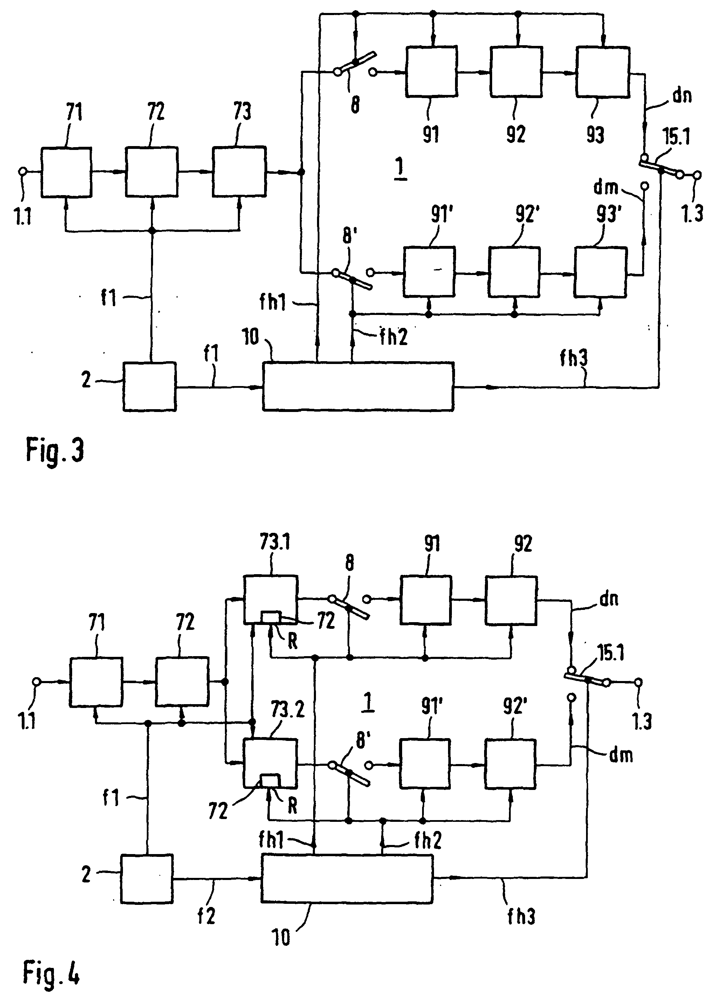

Die umschaltbare Filtereinrichtung 1 enthält in Signalflußrichtung einen Akkumulator 7, einen Dezimierungsschalter 8 und einen Differenzierer 9. Den Akkumulator 7 bildet eine Ringschaltung aus einem Addierer 7.2 und einer Verzögerungseinrichtung 7.1, wobei der Ausgang des Addierers 7.2 mit dem Eingang des Dezimierungsschalter 8 verbunden ist, dessen Steuereingang von einem Hilfstakt fh gesteuert ist, der über eine Steuereinrichtung 10 mit der ersten Taktquelle 2 oder mit dem ersten Takt f1 verkoppelt ist. Der Hilfstakt fh ist dabei eine nichtäquidistante Taktfolge, vgl. in Fig. 4 den Impulszug fh, bei der jeweils nach a oder a + 1 Taktschritten T1 des ersten Taktes f1 ein Impuls ausgelöst wird. Mit jedem Impuls des Hilfstaktes fh wird der Dezimierungsschalter 8 geschlossen, so daß der Inhalt des Akkumulators 7 über den Signalausgang des Dezimierungsschalters 8 dem Differenzierer 9 zugeführt wird. Der Differenzierer besteht aus einer Verzögerungseinrichtung 9.1 und einem Subtrahierer 9.2, dessen Minuend-Eingang 9.3 mit dem Eingang der Verzögerungseinrichtung 9.1 und dem Signalausgang des Dezimierungsschalters 8 verbunden ist. Der Ausgang der Verzögerungseinrichtung 9.1 ist dem Subtrahend-Eingang 9.4 zugeführt, so daß der jeweilige Inhalt der Verzögerungseinrichtung 9.1 vom aktuellen Akkumulatorinhalt abgezogen wird. Dieser Subtraktionsvorgang erfolgt immer dann, wenn der Hilfstakt fh den Dezimierungsschalter 8 schließt.

Der Wert des gefilterten Datenwerts df' am Ausgang 1.2 der Filtereinrichtung 1 ist somit der Summenwert der Eingangsdatenfolge d1 in einem mitlaufenden Datenfenster dw (vgl. Fig. 4), dessen Länge durch das zugehörige Taktintervall des Hilfstaktes fh gebildet wird. Springt beispielsweise der Hilfstakt fh alternierend zwischen zwei und drei Abtastwerten des ersten Taktes f1 hin und her, dann findet eine Reduktion der Datenrate um den Faktor r = 2,5 statt. Ist der Hilfstakt fh im zeitlichen Mittel aus drei Datenfenstern mit jeweils b = 2 Abtastwerten und zwei Datenfenstern mit jeweils c = 3 Abtastwerten gebildet, dann entspricht dies einer Reduktion der Datenrate um den Faktor r = 2,4. Es lassen sich auf diese Weise nicht nur diese einfachen Abtastratenverhältnisse reduzieren sondern über ganzzahlige Zwischenumsetzungen auch wesentlich kompliziertere, beispielsweise die Anpassung eines Audiosignals, das mit einer Datenrate von 18,43 MHz empfangen wird an einen Systemtakt von 20,25 MHz, wobei die resultierende, relativ niederfrequente Datenrate letztendlich im Bereich von 32 kHz liegt.

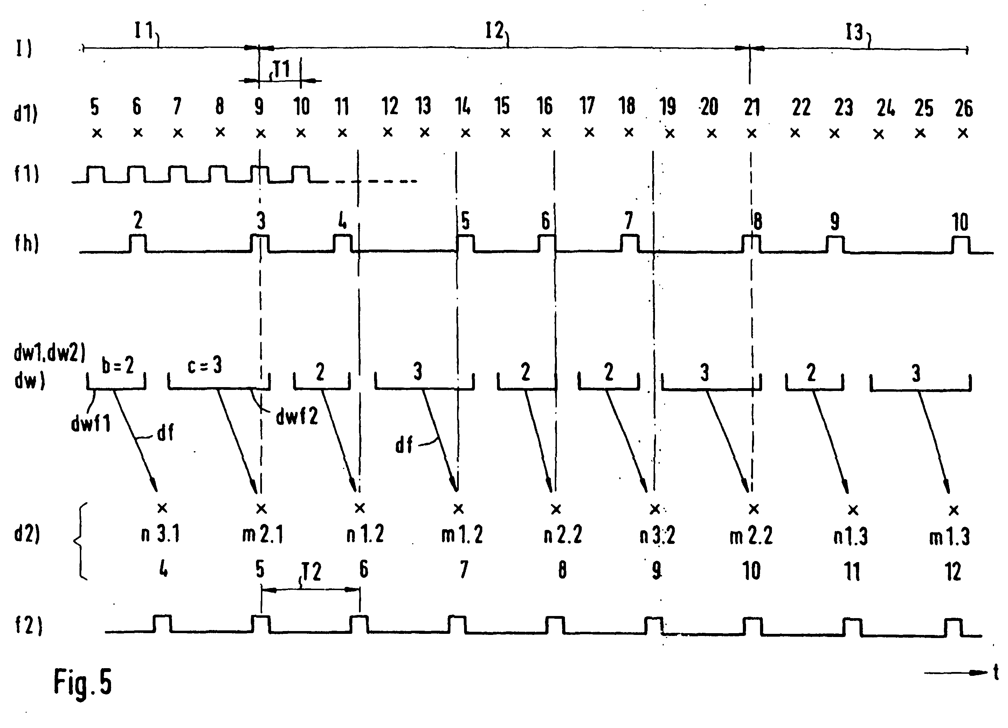

Die Steuereinrichtung 10 läßt sich beispielsweise durch einen rücksetzbaren Zähler realisieren, der vom ersten Takt f1 getaktet ist und der entsprechend dem Zahlenbeispiel von Fig. 5 mit einem Reduktionsfaktor r=2.4 immer bei der Zahl 12 zurückgesetzt wird. Die vom Eingangstakt f1 abhängigen Zählwerte 0,5 und 7 lösen den ersten Schaltzustand und die Zählwerte 2 und 9 den zweiten Schaltzustand aus. Die auslösenden Zählwerte einschließlich des Rücksetzwertes können in einer Tabelle gespeichert sein, die über den Reduktionsfaktor r als Adresse abrufbar ist. Über einen Bus kann der Inhalt eines entsprechenden Schreib/Lesespeichers vom Anwender oder von einer externen oder interen Rechenschaltung verändert werden, so daß beliebig viele Reduktionsfaktoren r realisiert werden können.

In Fig. 2 ist ein Ausführungsbeispiel der Erfindung mit einer einfachen parallelen Kammfilterstruktur dargestellt. Dabei sind Funktionseinheiten, die mit denen von Fig. 1 identisch sind, gegebenenfalls mit gleichen Bezugszeichen versehen, so daß sich eine nochmalige Erörterung erübrigt. Die wesentlichen Unterschiede gegenüber Fig. 1 bestehen in der Parallelschaltung eines ersten Filters 7,8,9 mit einem zweiten Filter 7', 8',9' und einer Kombinationseinrichtung 15, um die gefilterten Ausgangswerte df', df' des ersten und zweiten Filters zu einer einzigen Datenfolge d2 zusammenzufügen.

Die Kombinationseinrichtung 15 besteht im wesentlichen aus einem Umschalter 15.1, der entweder eine Verbindung mit dem Ausgang des ersten Filters 7, 8,9, um dort die ersten Ausgangswerte dn oder eine Verbindung mit dem Ausgang des zweiten Filters 7', 8', 9' herstellt, um dort die zweiten Ausgangswerte dm abzugreifen. Der Ausgang 1.3 der Kombinationseinrichtung 15 ist dann wie in Fig. 1 mit einem Pufferspeicher 5 verbunden.

Das erste Filter 7,8,9 bildet jeweils nach a Abtastwerten der Eingangsfolge d1 einen neuen Ausgangswert df'. Das zweite Filter 7', 8', 9' bildet unabhängig vom ersten Filter jeweils nach a + 1 Abtastwerten der Eingangsfolge d1 einen neuen Ausgangswert df2''. Die Bildung der Ausgangswerte df', df'' muß nicht gleichförmig sein, sondern hängt von dem gewünschten Reduktionsfaktor r ab. Durch die Schließung der Dezimierungsschalter 8,8' wird jeweils ein neues Datenfenster dw1 bzw. dw2 gestartet, wobei der Startzeitpunkt durch die Steuereinrichtung 10 mittels der Steuersignale fh1 bzw. fh2 definiert ist. Gleichzeitig mit der Schließung der Dezimierungsschalter 8,8' wird am jeweiligen Filterausgang ein neuer Ausgangswert df',df'' gebildet, der dem vorherigen Datenfenster zugeordnet ist und von der Kombinationseinrichtung 15 weitergeleitet oder ignoriert werden kann. Dies hängt von der Schaltposition des Umschalters 15.1 ab, der von einem Steuersignal fh3 gesteuert ist. Die drei Steuersignale fh1,fh2,fh3 sind mit einem Hilfstakt fh verkoppelt, der entsprechend der Anzahl n und m der ersten bzw. zweiten Ausgangswerte dn bzw. dm nach der bereits angegebenen Bemessungsregel r = a + m/(m + n) gebildet ist.

In dem Ausführungsbeispiel von Fig. 2 enthalten die Ausgänge des ersten und zweiten Filters jeweils noch eine Amplituden-Normierungseinrichtung 4,4', um die unterschiedlichen Verstärkungen auszugleichen. Die zugehörigen Abschwächungsfaktoren k1,k2 sind von der Steuereinrichtung 10 gebildet und haben beispielsweise die Werte k1 = 1/b und k2 = 1/c. Wird die Amplituden-Normierungseinrichtung, die in der Regel Multiplizierer und/oder Stellenverschiebungseinrichtungen enthalten, nach dem Anschluß 1.3 eingefügt, dann kann eine der Normierungseinrichtungen entfallen. Je nach dem Verwendungszweck der Datenfolge und dem Wert des Reduktionsfaktors r muß noch nicht einmal zwischen unterschiedlichen Verstärkungen umgeschaltet werden.

In den Ausgang des ersten Filters ist eine Verzögerungseinrichtung 16 eingefügt, mit der die unterschiedlichen Gruppenlaufzeiten des ersten und zweiten Filters in ganzen Taktschritten des Eingangstaktes f1 ausgeglichen werden können. Durch rechtzeitiges Starten des Datenfensters in Verbindung mit dem Gruppenlaufzeitausgleich werden somit beim Umschaltzeitpunkt vom ersten auf das zweite Filter Unstetigkeiten in der Datenfolge d2 weitgehend vermieden. Der Gruppenlaufzeitausgleich ist insbesondere bei Filtern höherer Ordnung wichtig, weil dort die Unterschiede mit der Ordnungszahl zunehmen. Die parallele Filterstruktur, die gegebenenfalls durch weitere parallelgeschaltete Filter ergänzt werden kann, ermöglich in Verbindung mit zugehörigen Verzögerungseinrichtungen eine vollständige Entkopplung der Start- und Schließzeitpunkte der Datenfenster, auch wenn sich die Datenfenster überlappen sollten. Im Falle von mehr als zwei parallelgeschalteten Filtern wird die Steuerung zwar etwas aufwendiger, aber das in Fig. 2 beschriebene Grundprinzip der Umschaltung parallelgeschalteter Filter bleibt erhalten.

Die in Fig. 2 dargestellte umschaltbare Filtereinrichtung 1 mit zwei Kammfiltern ersten Grades enthält im Eingang zwei Akkumulatoren 7,7', deren Ein- und Ausgangssignale identisch sind. Somit kann einer dieser Akkumulatoren 7,7' entfallen und der Ausgang des anderen ist mit den beiden Dezimierungsschaltern 8, 8' verbunden. Ein ähnliches Beispiel für die Einsparung von Akkumulatoren zeigt die Filteranordnung von Fig. 3, die einer Parallelschaltung zweier Kammfilter dritten Grades entspricht. Die hintereinandergeschalteten drei Akkumulatoren 71,72,73 sind ausgangsseitig mit den beiden Dezimierungsschaltern 8,8', denen jeweils drei Differenzierer 91,92,93 bzw. 91', 92', 93' folgen, verbunden.

In Fig. 4 ist eine umschaltbare Filtereinrichtung 1 dargestellt, deren Übertragungsfunktion identisch zur Übertragungsfunktion von Fig. 3 ist. Die Realisierung der umschaltbaren Filtereinrichtung 1 unterscheidet sich jedoch von der von Fig. 3 dadurch, daß in den beiden Filterzweigen jeweils nur zwei Dezimierer 91, 92 bzw. 91', 92' und von den hintereinandergeschalteten Akkumulatoren nur die Akkumulatoren 71,72 in Serie geschaltet sind und für jeden Filterzweig ein eigener dritter Akkumulator 73.1 bzw. 73.2 vorhanden ist. Die beiden dritten Akkumulatoren 73.1,73.2 sind Akkumulatoren mit einer Rücksetzeinrichtung 72, die gleichzeitig mit dem zugehörigen Dezimierungsschalter 8 bzw. 8' zurückgesetzt wird. Durch die Verwendung der rücksetzbaren Akkumulatoren 73.1, 73.2 kann in dem jeweiligen Filterzweig ein Dezimierer eingespart werden, dafür ist jedoch ein zusätzlicher rücksetzbarer Akkumulator 73.2 für den zweiten Filterzweig erforderlich, weil der erste rücksetzbare Akkumulator 73.1 dem ersten Filterzweig zugeordnet wird. Durch das erste oder zweite Steuersignal fh1, fh2 am Rücksetzeingang R wird der Start des jeweiligen Datenfensters ausgelöst. Es wird darauf hingewiesen, daß es für den Startzeitpunkt des Datenfensters dw1,dw2 unerheblich ist, wann das letzte Steuersignal fh1 bzw. fh2 ausgelöst wurde. Die Auswahl der richtigen Ausgangswerte dn bzw. dm erfolgt durch den Umschalter 15.1.

Die Bildung der Steuersignale fh1,fh2, fh3 des Hilfstaktes fh erfolgt in der Steuereinrichtung 10 beispielsweise mittels des bereits erwähnten rücksetzbaren Zählers und gespeicherter Zählwerte. Die gespeicherten Zählwerte können in einer Tabelle abgelegt sein, die mittels des Reduktionsfaktors r adressierbar ist. Ein Zahlenbeispiel soll nochmals verdeutlichen, wie beim Wechsel der Abtastrate zeitliche Sprünge und damit Unstetigkeiten in der Ausgangsdatenfolge d2 verhindert werden. Es ist dabei darauf zu achten, daß die Zähler für das erste und zweite Filter mit einer geeigneten Verzögerung zueinander gestartet werden. Die Verzögerung ist dabei so zu wählen, daß zum Zeitpunkt des Wechsels der Abtastung an beiden Filterausgängen ein neuer Ausgangswert dn bwz. dm abgreifbar ist. Verwendet man beispielsweise Kammfilter dritter Ordnung, also jeweils drei Akkumulatoren und drei Differenzierer und der Abtastraten-Reduktionsfaktor r liegt zwischen 49 Takten und 50 Takten, so muß der Zähler für das ersten Filter 3 Takte nach dem Zähler für das zweite Filter gestartet werden. Dann liegt nach 3 × 49 + 3 Takten, das sind insgesamt 150 Takte, am ersten Filterausgang ein neuer gefilteter Abtastwert df' vor. Da der Zähler für das zweite Filter drei Takte später gestartet wurde, liegt nach 3 x 50 Takten, das sind ebenfalls 150 Takte, dort ein neuer gefilteter Ausgangswert df'' vor. Der Unterschied der Gruppenlaufzeit ist hierbei jedoch nicht berücksichtigt, so daß in dem ersten Filterzweig mittels einer nicht dargestellten Verzögerungseinrichtung (vgl. Fig. 2) ein gewisser Ausgleich erreicht werden kann. Die Unterschiede der Gruppenlaufzeiten betragen 1,5 Takte.

Die Gruppenlaufzeiten hängen von der Ordnungszahl der Filter und der jeweiligen Fenstergröße ab und ergeben sich aus der Übertragungsfunktion. An einem Zahlenbeispiel mit einem Kammfilter zweiter Ordnung, das zwischen den Abtastraten 2 und 3 umgeschaltet wird, soll dies anhand der komplexen Übertragungsfunktion H(z) verdeutlicht werden. Wird in stetiger Folge jeweils nach zwei Abtastwerten ein neuer Ausgangwert gebildet wird gilt folgende Übertragungsfunktion:

$$H(z) = ((1 - z^{-2}) / (1 - z^{-1}))^2 = 1 + 2z^{-1} + z^{-2} \qquad (1)$$

Das mitlaufende Datenfenster dw umfaßt drei Werte der Datenfolge d1, und die umschaltbare Filtereinrichtung 1 befindet sich im ersten Schaltzustand.

Werden die Abtastintervalle von zwei auf drei oder von drei auf zwei Taktperioden T1 umgeschaltet so realisiert die Schaltung für den jeweiligen Abtastwert die Übertragungsfunktion:

$$H(z) = (1 - z^{-2}) \times (1 - z^{-3}) / (1 - z^{-1})^2 = 1 + 2z^{-1} + 2z^{-2} + z^{-3} \qquad (2)$$

Das mitlaufende Datenfenster umfaßt vier Abtastwerte. Die umschaltbare Filtereinrichtung 1 ist hierbei je nach dem Endzustand des Wechsels dem zweiten oder dem ersten Schaltzustand zuzurechnen.

Wird in stetiger Folge jeweils nach drei Abtastwerten eine neuer Ausgangswert gebildet, so realisiert die Schaltung die Übertragungsfunktion:

$$H(z) = ((1 - z^{-3}) / (1 - z^{-1}))^2 = 1 + 2z^{-1} + 3z^{-2} + 2z^{-3} + z^{-4} \qquad (3)$$

Hierbei umfaßt das mitlaufende Datenfenster fünf Abtastwerte und die umschaltbare Filtereinrichtung befindet sich im zweiten Schaltzustand.

In der Regel wird nur zwischen den Übertragungsfunktionen (1) und (2) oder den Übertragungsfunktionen (2) und (3) umgeschaltet, weil die Folge der ersten und zweiten Ausgangswerte möglichst alternierend sein soll. Die Übertragungsfunktionen (1) und (2) sind nur dann anzuwenden, wenn der vorausgehende Schaltzustand identisch war. Bei einem Reduktionsfaktor r=2,9 kämen beispielsweise die Übertragungsfunktionen (2) und insbesondere (3) in Betracht, weil entsprechend der Bemessungsregel $r = a + m/(n+m)$ auf neun zweite Abtastwerte dm mit drei Abtastschritten nur ein erster Abtastwert dn mit zwei Abtastschritten kommt. Eine bessere Alternierung ist hier nicht möglich. Noch mehr gilt dies, wenn das Abtastratenverhältnis gegenüber den beiden Abtastintervallen a und a+1 noch einseitiger liegt, beispielsweise für einen Abtastraten-Reduktionsfaktor r = 2,99.

Die einzelnen Übertragungsfunktionen (1), (2) und (3) zeigen, daß zur Bildung der gefilterten Datenwerte df eine unterschiedliche Gewichtung der Abtastwerte in dem jeweiligen Datenfenster dw vorliegt. Aus dem Beispiel ist ferner ersichtlich, daß die Verstärkung im ersten Schaltzustand den Wert 4, im Wechselzustand den Wert 6 und im zweiten Schaltzustand den Wert 9 hat. Mittels der Amplituden-Normierungseinrichtung 4 und dem Abschwächungsfaktor k können die unterschiedlichen Verstärkungen für die gefilterten Datenwerte df ausgeglichen werden.

Aus dem Beispiel mit dem Kammfilter zweiten Grades kann auch die rein programmgesteuerte Realisierung leicht erkannt werden, indem die einzelnen Abtastwerte zunächst zwischengespeichert und mit der entsprechenden Gewichtung mittels eines vorhandenen Rechenwerkes in einem Prozessor addiert werden. Die Nachbildung mit Akkumulatoren, Dezimierungsschaltern und Differenzierern ist hierfür nicht erforderlich.

In Fig. 5 ist zur Verdeutlichung der Erfindung ein Zeitdiagramm dargestellt, das anschaulich die Funktion der Schaltung nach Fig. 1 oder Fig. 2 bei einem Datenrate-Reduktionsfaktor r = 2,4 zeigt. Von einer Eingangsdatenfolge d1 sind schematisch die Abtastzeitpunkte als liegende Kreuze dargestellt, die von 5 bis 26 durchnummeriert sind. Diese Datenfolge d1 ist in gleichlange Zeitabschnitte 1 bzw. l1,l2,l3 eingeteilt, die jeweils 12 Abtastintervalle T1 umfassen, die durch den ersten Takt f1 zeitlich definiert sind. In der Darstellung ist der erste und dritte Abschnitt l1,l3 unvollständig, der vollständige zweite Abschnitt l2 reicht vom Abtastwert 9 bis zum Abtastwert 21. Für den gewünschten Abtastratenreduktionsfaktor r = 2,4 müssen die zwölf Taktperioden T1 umfassenden Abschnitte l1,l2,l3 jeweils in drei Unterabschnitte mit zwei Taktperioden T1 und zwei Unterabschnitte mit drei Taktperioden T1 unterteilt werden. Den einzelnen Abschnitten entspricht dabei mindestens ein mitlaufendes Datenfenster dw bzw. dw1, dw2, dessen erste Fenstergröße dwf1 entweder b = 2 oder dessen zweite Fenstergröße dwf2 c = 3 Abtastwerte zur Mittelwertbildung umfaßt. Wenn entsprechend einer parallelen Filterstruktur zwei unabhängige mitlaufende Datenfenster dw1, dw2 vorhanden sind, dann ist dem ersten Datenfenster dw1 die Fenstergröße dwf1 und dem zweiten Datenfenster dw2 die Fenstergröße dwf2 zugeordnet. Die Fenstergröße dwf1 mit b Abtastwerten entspricht dem ersten Schaltzustand und die Fenstergröße dw2 mit c Abtastwerten entspricht dem zweiten Schaltzustand der umschaltbaren Filtereinrichtung 1.

Im Zeitdiagramm von Fig. 5 ist auch zu sehen, daß der nicht äquidistante Hilfstakt fh und die mitlaufende Datenfenster mit den Fenstergrößen dwf1, dwf2 zeitlich mit der Eingangsdatenfolge d1 und damit mit dem ersten Takt f1 verkoppelt sind.

Aus der Mittelwertbildung der Abtastwerte im jeweiligen Datenfenster dw bzw. dw1, dw2 werden die gefilterten Datenwerte df gebildet, die im Pufferspeicher 5 zwischengespeichert werden, bis sie vom zweiten Takt f2, dem Ausgangstakt, abgerufen werden und die n ersten oder m zweiten Ausgangswerte dn bzw. dm der Datenfolge d2 bilden. Beispielsweise bilden die Abtastwerte 5 und 6 der Folge d1 den Ausgangswert n3.1 der Datenfolge d2. Die letzten Abtastwerte 7,8,9 im Intervall I1 bilden den Ausgangswert m2.1, der als letzer Wert noch dem Intervall I1 zuzurechnen ist. Der erste Ausgangswert, der dem zweiten Intervall I2 zuzurechnen ist, ist der Ausgangswert n1.2, der aus den Abtastwerten 10 und 11 der Datenfolge d1 gebildet wird.

Je nach der Fenstergröße dwf1 bzw. dwf2 des zugehörigen Datenfensters wird bei der Datenfolge d2 zwischen ersten Ausgangswerten dn (in Fig. 5 mit n... bezeichnet) und zweiten Ausgangswerten dm (in Fig. 5 mit m... bezeichnet) unterschieden. Die von n3.1 bis m1.3 reichende Datenfolge d2 ist in Fig. 5 von 4 bis 12 durchnummeriert. Da die Datenfolge d2 mit dem Ausgangtakt f2 zeitlich verkoppelt ist, folgen die neuen Abtastwerte n3.1 bis m1.3 äquidistant aufeinander, wobei die Datenrate durch die Periode T2 bestimmt ist.

Nach jeweils I2 Abtastschritten T1 ergibt sich eine Koinzidenz zwischen dem ersten und zweiten Takt f1, f2. Dies ist jedoch nicht zwingend, denn in der Realität können Phasendifferenzen zwischen dem ersten und zweiten Takt f1, f2 durch den Pufferspeicher 5 ausgeglichen werden. Es ist sogar möglich, daß ein ganzer Block von gefilterten Datenwerten df in einem großen Pufferspeicher, beispielsweise einem FIFO-Speicher (FIFO = First-In-First-Out), zwischengespeichert wird und dann burstweise mit einer ganz anderen Frequenz ausgelesen wird.

**Patentansprüche**

1.  Einrichtung zur Reduktion der Datenrate einer Datenfolge (d1) mit

    - einer umschaltbaren Filtereinrichtung (1), die in einem ersten Schaltzustand erste Ausgangswerte (dn) nach a Abtastschritten und in einem zweiten Schaltzustand zweite Ausgangswerte (dm) nach a + 1 Abtastschritten liefert und zur Bildung gefilterter Datenwerte (df'; df', df'') mindestens ein mitlaufendes Datenfenster (dw; dw1, dw2) aufweist, wobei im Falle

    - nur eines mitlaufenden Datenfensters (dw) diesem mindestens zwei unterschiedliche Fenstergrößen (dwf1,dwf2) zugeordnet sind, deren Auswahl von der Folge der ersten (dn) und zweiten Ausgangswerte (dm) abhängig ist, oder

    - bei mehr als einem mitlaufenden Datenfenster (dw1,dw2) diesen mindestens zwei unterschiedliche Fenstergrößen (dwf1,dwf2) zugeordnet sind und die Auswahl des jeweiligen Datenfensters (dw1,dw2) mit der zugehörigen Fenstergröße von der Folge der ersten (dn) und zweiten Ausgangswerte (dm) abhängig ist, und

    - die eine Fenstergröße (dwf1) b Abtastwerte und die andere Fenstergröße (dwf2) c Abtastwerte mit $b \geq a$ und $c \geq a + 1$ umfaßt, und

    - einer mit der umschaltbaren Filtereinrichtung (1) gekoppelten Steuereinrichtung (10), die mittels des ersten und zweiten Schaltzustandes innerhalb gleichlanger Abschnitte (I2) der Datenfolge (d1) die Bildung von n ersten Ausgangswerten (dn), m zweiten Ausgangswerten (dm) und die Auswahl der zugehörigen Fenstergrößen (dwf1,dwf2) oder Datenfenster (dw1,dw2) bewirkt, dabei ist die Anzahl der n ersten (dn) und m zweiten Ausgangswerte (dm) durch eine Bemessungsregel $r = a + m/(n+ m)$ bestimmt, wobei r ein Datenrate-Reduktionsfaktor ist.

2.  Einrichtung nach Anspruch 1, **dadurch gekennzeichnet, daß** die umschaltbare Filtereinrichtung (1) der Parallelschaltung von einem ersten und einem zweiten Filter (7,8,9; 7', 8', 9') entspricht, die die n ersten (dn) bzw. m zweiten Ausgangswerte (dm) erzeugen, die mittels einer Kombinationseinrichtung (15) zu einer Datenfolge (d2) zusammengefügt sind.

3.  Einrichtung nach Anspruch 2, **dadurch gekennzeichnet, daß** das erste bzw. zweite Filter (7,8,9;7',8', 9') einem ersten bzw. zweiten Kammfilter beliebiger Ordnung entspricht.

4.  Einrichtung nach Anspruch 3 **dadurch gekennzeichnet, daß** dem ersten und dem zweiten Kammfilter jeweils in Signalflußrichtung entweder

    - p Akkumulatoren (71,72,73;17',72',73'), ein Dezimierungsschalter (8, 8') und p Differenzierer (91, 92,93; 91', 92', 93') oder

    -   p Akkumulatoren (71,72, 73.1;71,72,73.2), ein Dezimierungschalter (8, 8') und p-1 Differenzierer (91, 92; 91', 92') zugeordnet sind, wobei der in Signalflußrichtung liegende letzte Akkumulator (73.1;73.2) mittels einer Rücksetzeinrichtung (72) gleichzeitig mit der Schließung des Dezimierungsschalters (8, 8') zurückgesetzt wird und p ≥ 1 ist.

**5.** Einrichtung nach einem der Ansprüche 1 bis 4, **dadurch gekennzeichnet, daß** mittels einer Amplituden-Normierungseinrichtung (4; 4,4') die unterschiedlichen Verstärkungen der umschaltbaren Filtereinrichtung (1) mindestens teilweise kompensiert sind.

**6.** Einrichtung nach einem der Ansprüche 1 bis 4, **dadurch gekennzeichnet, daß** mittels einer Ausgleichseinrichtung (16) unterschiedliche Gruppenlaufzeiten der umschaltbaren Filtereinrichtung (1) einander angepasst sind.

**7.** Einrichtung nach Anspruch 6, **dadurch gekennzeichnet, daß** die Ausgleichseinrichtung (16) eine Verzögerungseinrichtung enthält.

**8.** Einrichtung nach Anspruch 7, **dadurch gekennzeichnet, daß** mittels einer Recheneinrichtung in der Steuereinrichtung (10) der Aktivierungszeitpunkt des Dezimierungsschalters (8; 8,8') und / oder der Rücksetzeinrichtung (72) bestimmt ist.

**Claims**

**1.** A facility for reducing the data rate of a data sequence (d1), comprising:

    -   a switchable filter device (1) which delivers first output values (dn) after a sampling intervals in a first state and second output values (dm) after a + 1 sampling intervals in a second state, and has at least one tracking data window (dw; dw1, dw2) for forming filtered data values (df'; df', df''), wherein

        --   if only one tracking data window (dw) is present, this data window (dw) is assigned at least two different window sizes (dwf1, dwf2) whose selection is dependent on the sequence of the first (dn) and second output values (dm), or

        --   if more than one tracking data window (dw1, dw2) are present, these are assigned at least two different window sizes (dwf1, dwf2), and the selection of the respective data window (dw1, dw2) with the associated window size is dependent on the sequence of the first (dn) and second output values (dm), and

        --   one (dwf1) of the window sizes (dwf1, dwf2) comprises b samples, and the other (dwf2) c samples, with b ≥ a and c ≥ a + 1; and

    -   a control device (10) which is coupled to the switchable filter device (1) and, by means of the first and second states, causes the formation of n first output values (dn) and m second output values (dm) as well as the selection of the associated window sizes (dwf1, dwf2) or data windows (dw1, dw2) within equally long time periods (12) of the data sequence d1, the number of n first (dn) and m second output values (dm) being determined by a rule r = a + m/(n+m), where r is a data rate reduction factor.

**2.** A facility as claimed in claim 1, **characterized in that** the switchable filter device (1) corresponds to the parallel combination of a first filter,(7, 8, 9) and a second filter (7', 8', 9') which produce the n first (dn) and m second output values (dm), respectively, which are combined into a data sequence (d2) by a combining device (15).

**3.** A facility as claimed in claim 2, **characterized in that** the first filter (7, 8, 9) and the second filter (7', 8', 9') correspond, respectively, to a first comb filter and a second comb filter of arbitrary order.

**4.** A facility as claimed in claim 3, **characterized in that** in the direction of signal flow, the first and second comb filters are each assigned either

    -   p accumulators (71, 72, 73), a decimation switch (8, 8'), and p differentiators (91, 92, 93; 91', 92', 93') or
    -   p accumulators (71, 72, 73.1; 71, 72, 73.2), a decimation switch (8, 8'), and p-1 differentiators (91, 92; 91', 92'), with the last accumulator (73.1; 73.2) in the direction of signal flow being reset by means of a resetting facility (73.3) simultaneously with the closure of the decimation switch (8, 8'), and with p ≥ 1.

5. A facility as claimed in any one of claims 1 to 4, **characterized in that** the different gains of the switchable filter device (1) are compensated for, at least in part, by means of an amplitude-normalizing device.

6. A facility as claimed in any one of claims 1 to 4, **characterized in that** by means of an equalizing device (16), different groups delays of the switchable filter device (1) are adapted to one another.

7. A facility as claimed in claim 6, **characterized in that** the equalizing device (16) includes a delay element.

8. A facility as claimed in claim 7, **characterized in that** by means of a computing device in the control device (10), the time of activation of the decimation switch (8; 8, 8') and/or of the resetting facility (73.3) is determined.

## Revendications

1. Dispositif pour la réduction du débit de données d'une suite de données (d1) comportant :

   - un dispositif de filtrage (1) pouvant être commuté qui fournit, dans un premier état de commutation, des premières valeurs de sortie (dn) après a étapes d'échantillonnage et dans un deuxième état de commutation, des deuxièmes valeurs de sortie (dm) après a + 1 étapes d'échantillonnage et qui comporte, pour la formation de valeurs de données filtrées (df , df', df''), au moins une fenêtre de données (dw ; dw1, dw2), dispositif dans lequel :

   - dans le cas où il y a seulement une fenêtre de données (dw) en fonction, on associe à cette dernière deux grandeurs de fenêtre différentes (dwf1, dwf2) dont le choix dépend de la séquence des première (dn) et deuxième (dm) valeurs de sortie,
   - dans le cas où il y a plus d'une fenêtre de données (dw1, dw2) en fonction, on associe à celles-ci au moins deux grandeurs de fenêtre différentes (dw1, dw2) et le choix de chaque fenêtre de données (dw1, dw2) avec la grandeur de fenêtre correspondante dépend de la séquence des première (dn) et deuxième (dm) valeurs de sortie, et
   - l'une des grandeurs de fenêtre (dwf1) comprend b étapes d'échantillonnage et l'autre comprend c étapes d'échantillonnage, avec b ≥ a et c ≥ a + 1,
   - ledit dispositif comprend un dispositif de commande (10) qui est couplé au dispositif de filtrage (1) pouvant être commuté et qui cause, au moyen du premier et du deuxième état de commutation, à l'intérieur de sections (l2) de même longueur de la suite de données (d1), la formation de n premières valeurs de données (dn) et de m deuxièmes valeurs de données (dm) et le choix des grandeurs de fenêtre différentes (dwf1, dwf2) ou fenêtre de données (dw1, dw2) correspondantes, les nombres des n premières valeurs de données (dn) et de m deuxièmes valeurs de données (dm) étant déterminés par une règle de calcul r = a + m/(n+m), dans laquelle r est un facteur de déduction du débit de données.

2. Dispositif selon la revendication 1, **caractérisé en ce que** le dispositif de filtrage (1) pouvant être commuté correspond au branchement en parallèle d'un premier et d'un deuxième filtres (7, 8, 9 ; 7', 8', 9') qui produisent les n premières valeurs de données (dn), respectivement les m deuxièmes valeurs de données (dm) qui sont assemblées pour former une suite de données (d2) au moyen d'un dispositif de combinaison (15).

3. Dispositif selon la revendication 2, **caractérisé en ce que** le premier, respectivement le deuxième filtre (7, 8, 9 ; 7', 8', 9') correspondent à un premier, respectivement deuxième filtre en peigne d'ordre arbitraire.

4. Dispositif selon la revendication 3, **caractérisé en ce que** l'on associe aux premier et deuxième filtres en peigne, à chaque fois dans la direction du flux des signaux,

   - soit p accumulateurs (71, 72, 73 ; 71', 72', 73'), un commutateur de décimation (8, 8') et p circuits différentiateurs (91, 92, 93 ; 91', 92', 93'),
   - soit p accumulateurs (71, 72, 73 ; 71', 72', 73'), un commutateur de décimation (8, 8') et (p - 1) circuits différentiateurs (91, 92 ; 91', 92'), le dernier accumulateur (73.1, ; 73.2) se trouvant dans la direction du flux des signaux étant remis à zéro en même temps que la fermeture du commutateur de décimation (8, 8') au moyen d'un dispositif de remise à zéro (72), avec $p \geq 1$.

5. Dispositif selon l'une quelconque des revendications 1 à 4, **caractérisé en ce que** l'on compense, au moins partiellement, les différentes amplifications du dispositif de filtrage (1) pouvant être commuté au moyen d'un dispositif de cadrage de l'amplitude (4 ; 4, 4').

6. Dispositif selon l'une quelconque des revendications 1 à 4, **caractérisé en ce que** l'on adapte les uns aux autres des temps de propagation de groupe différents du dispositif de filtrage (1) pouvant être commuté au moyen d'un dispositif de compensation (16).

7. Dispositif selon la revendication 6, **caractérisé en ce que** le dispositif de compensation (16) comprend un dispositif de temporisation.

8. Dispositif selon la revendication 7, **caractérisé en ce que** l'on détermine l'instant d'activation du commutateur de décimation (8 ; 8, 8') et/ou du dispositif de remise à zéro (72) au moyen d'un dispositif de calcul se trouvant dans le dispositif de commande (10).

EP 0 889 587 B1

Fig.1

Fig.2

Fig. 3

Fig. 4

Fig. 5